# EUROPEAN PATENT APPLICATION

(11) **EP 1 480 078 A1**
(43) Date of publication of application: **24.11.2004**
(21) Application number: 04076494.6
(22) Date of filing: 19.05.2004
(51) Int. Cl.: G03F 1/14, G03F 7/11, G03F 7/09

(54) **Method for coating a substrate for EUV lithography and substrate with photoresist layer**

(30) Priority: 21.05.2003 EP 03076531
(71) Applicant: ASML Netherlands B.V., 5504 DR Veldhoven (NL)
(72) Inventor: Van Ingen Schenau, Koen, 5612 HB Eindhoven (NL); Dierichs, Marcel Mathijs Theodore Marie, 5914 WR Venlo (NL)
(74) Representative: van Westenbrugge, Andries

(57) **Abstract**

The invention is related to a method for coating a substrate for EUV lithography comprising coating a photoresist layer and a protective top coat on the substrate. It further relates to a device manufacturing method using a lithographic projection apparatus, wherein the method comprises:
- providing a substrate that is at least partially covered by a photoresist layer by coating the photoresist layer and a protective top coat on the substrate;
- providing a projection beam of radiation using a radiation system;
- using patterning means to endow the projection beam with a pattern in its cross-section; and
- projecting the patterned beam of radiation onto a target portion of the photoresist layer.

The present invention is also related to a substrate with photoresist layer and a protective top coat.

## Description

The present invention relates to a method for coating a substrate for EUV lithography comprising coating a photoresist layer on the substrate. It further relates to a device manufacturing method using a lithographic projection apparatus comprising:
- providing a substrate that is at least partially covered by a photoresist layer by coating the photoresist layer on the substrate;
- providing a projection beam of radiation using a radiation system;
- using patterning means to endow the projection beam with a pattern in its cross-section; and
- projecting the patterned beam of radiation onto a target portion of the photoresist layer.
The present invention is also related to a substrate with photoresist layer.

In a lithographic apparatus the size of features that can be imaged onto the substrate is limited by the wavelength of the projection radiation. To produce integrated circuits with a higher density of devices, and hence higher operating speeds, it is desirable to be able to image smaller features. Whilst most current lithographic projection apparatus employ ultraviolet light generated by mercury lamps or excimer lasers, it has been proposed to use shorter wavelength radiation, e.g. of around 13 nm. Such radiation is termed extreme ultraviolet (EUV) or soft x-ray, and possible sources include, for instance, laser-produced plasma sources, discharge plasma sources, or synchrotron radiation from electron storage rings.

When using EUV lithography, other requirements are imposed on the process conditions, apparatus and lithography methods, when compared to ultraviolet (UV e.g. 365 nm) or deep ultra violet (DUV e.g. 248 or 193 nm) lithography. Due to high absorption at EUV wavelengths a vacuum environment is required.

With respect to the use of photoresists, in the art a protective coating is disclosed. US 5240812 describes e.g. a method in which a substrate is coated with an acid catalysed resist, and wherein on the photoresist layer a second polymeric coating is provided. According to US 5240812 such coatings can be used for UV, but also e-beam and x-ray radiation. The coating is impermeable to vapours of organic and inorganic bases. Also Van Ingen Schenau et al. (Olin Microlithography seminar, October 27-29, 1996, San Diego CA) describe a top coat on a resist (for DUV application). The top coat is used to protect the photoresist against airborne contaminations.

A disadvantage is that commercially available top coats like Aquatar (from Clariant), which might be applied in EUV lithography, are on water basis. This may lead to unwanted absorption by EUV light by water. It may also lead to an undesired outgassing of water, which may also result in unwanted absorption of EUV radiation by water and/or degradation of mirror optics used in EUV lithographic systems. In this way, less reproducible lithographic results might be obtained.

Hence, it is an object of the present invention to provide a non-aqueous based top coat on a photoresist layer for EUV lithography that is EUV transmissive and which protects against contaminations.

According to the present invention, there is provided a method for coating a substrate for EUV lithography according to the opening paragraph, characterised by providing an EUV transmissive top coat on the photoresist layer, wherein the EUV transmissive top coat comprises a polymer comprising a group with one or more of the following atoms: beryllium, boron, carbon, silicon, zirconium, niobium and molybdenum.

More in particular, there is provided a device manufacturing method, using a lithographic projection apparatus, as specified in the opening paragraph, characterised by providing an EUV transmissive top coat on the photoresist layer, wherein the EUV transmissive top coat comprises a polymer comprising a group with one or more of the following atoms: beryllium, boron, carbon, silicon, zirconium, niobium and molybdenum.

The advantage of such an EUV transmissive top coat on the photoresist layer is that the layer protects the photoresist layer against contaminations that might be present in the atmosphere over the substrate. It further diminishes outgassing of contaminants like hydrocarbons and other compounds, like compounds comprising atoms selected from the group consisting of F, Si, P, S and Cl, originating from the photoresist and, if present, water from the photoresist. Such outgassing might harm e.g. mirror optics.

Another advantage is that an EUV transmissive top coat according to an embodiment of the invention is substantially transmissive for EUV radiation, but may substantially be non-transmissive or only slightly transmissive for undesired radiation, e.g. UV or DUV radiation. This leads to an increased spectral selectivity, which might possibly reduce the number of spectral filters present in e.g. a lithographic system. Further, in another embodiment, the EUV transmissive top coat can dissipate and conduct possible charge due to a relatively high conductance of the coat and thus, the top coat can be used as charge dissipating or conducting layer.

In one embodiment, the invention comprises a method wherein the EUV transmissive top coat comprises one or more of the following atoms: beryllium, boron, carbon, silicon, zirconium, niobium and molybdenum. Coatings comprising these elements may function as a spectral filter, being more transmissive for EUV radiation than for (D)UV radiation. For example, the transmission of a 10 nm Si layer for EUV (e.g. 13.5 nm) is about 98% and for DUV (e.g. 193 nm) only about 20%. This means that an EUV transmissive top coat according to the invention may make spectral purity filters less necessary or may permit a decrease in the number of spectral purity filters or other wavelength selective optics in EUV optical systems, like e.g. a lithographic apparatus.

In another embodiment, the invention comprises a method wherein the top coat comprises a polymer. For example, this can be a method wherein the polymer has a molecular weight of 500-15000 g/mol, preferably 1000-10000 g/mol. The polymer can comprise groups with one or more of the following atoms: beryllium, boron, silicon, zirconium, niobium and molybdenum.

In a further embodiment, the invention comprises a method wherein the polymers are based on Si, C and H, e.g. wherein the top coat comprises one or more of the following polymers (or polymer groups): polysilanes (e.g. polydimethylsilane, polymethyhydrosilane), polysilylenes, polysiloxanes, silylated polyhydroxystyrene (PHS), silane containing polymers, silsesquioxane polymers, acryl silane polymers, methacryl silane polymers, and silylated polymers (e.g. Si-containing Novolac).

An example of a possible polymer that can be used as top coat is Si-containing Novolac. Novolac has a high DUV absorption, improving the EUV/DLTV selectivity. Polymers, like Novolac, may be sylilated, in order to furhter improve EUV/DUV selectivity.

In another embodiment, polymers are used comprising boron, i.e. based on B, C and H, e.g. carborane polyamide, or a polymer that is boron-loaded (e.g. a boron loaded polyimide).

In a further embodiment, the invention comprises a method wherein the top coat comprises a solvent. In a specific embodiment, the solvent of the top coat is a solvent that is also used as solvent for coating the photoresist on the substrate (i.e. the same solvent is used for the photoresist layer as well for the EUV transmissive top coat).

Hence, in a specific embodiment the top coat might e.g. comprise a combination of a) one or more of the following atoms: beryllium, boron, carbon, silicon, zirconium, niobium and molybdenum, b) a solvent (e.g. a photoresist solvent) and c) a polymer. In a further aspect of this embodiment, the polymer in the EUV transmissive top coat comprises one or more of the following atoms: beryllium, boron, carbon, silicon, zirconium, niobium and molybdenum, and wherein the polymer in the EUV transmissive top coat comprising carbon, also comprises one of the other mentioned atoms. Such top coats can be applied on the surface of the photoresist layer, e.g. by spin coating. Hence, in another specific embodiment the top coat might e.g. comprise a) a polymer comprising a group with one or more of the following atoms: beryllium, boron, carbon, silicon, zirconium, niobium and b) a solvent (e.g. a photoresist solvent).
The method according to the invention for coating a substrate for EUV lithography may comprise:
- preparing a surface of a substrate, e.g. comprising cleaning and drying;
- coating a photoresist layer on the surface of the substrate, e.g. comprising spin coating a photoresist layer on the surface of the substrate;
- heating the substrate during softbake, wherein a partial evaporation of the photoresist solvents take place by heating,
- cooling the substrate during "chilling";
- providing an EUV transmissive top coat on the surface of the photoresist layer, e.g. comprising spin coating an EUV transmissive top coat on the surface of the photoresist layer. Alternatively, in another embodiment, an EUV transmissive top coat is applied on the photoresist layer, immediately after the coating of the photoresist layer.

In another embodiment, the EUV transmissive top coat is provided on the surface of the photoresist layer by chemical vapour deposition (CVD). In this way, an EUV transmissive top coat is created, comprising one or more of the following atoms: beryllium, boron, carbon, silicon, zirconium, niobium and molybdenum. Such top coats can e.g. be based on Si, C and H; or B, C and H, or a combination thereof.

In a specific embodiment, a polymer and one or more of beryllium, boron, carbon, silicon, zirconium, niobium and molybdenum, are coated as top coat by CVD. In this way, a polymer top coat is provided comprising one or more of beryllium, boron, carbon, silicon, zirconium, niobium and molybdenum components. In a further aspect of this embodiment, the polymer in the EUV transmissive top coat, provided by CVD, comprises one or more of the following atoms: beryllium, boron, carbon, silicon, zirconium, niobium and molybdenum, and wherein the polymer in the EUV transmissive top coat comprising carbon, also comprises one of the other mentioned atoms. In this way, EUV transmissive top coats based on e.g. Si, C and H, or B, C and H, can be obtained by CVD.

The embodiments of the invention preferably lead to EUV transmissive top coats, wherein the top coat has a final thickness such that the transmission of EUV radiation is higher than 50%, preferably more than 80%. In a further embodiment, the invention provides a method wherein the top coat has a transmission for DUV and UV radiation of less than 50%. The top coat may have a final thickness of 20-100 nm, preferably 30-80 nm.

In another aspect of the invention, the invention is also directed to a coat for use as top coat on a photoresist layer, wherein the coat comprises a polymer comprising a group with one or more of the following atoms: beryllium, boron, carbon, silicon, zirconium, niobium and molybdenum, and wherein the coat enables at least on of a) a diminishing of outgassing of a contaminant from the photoresist layer and b) preventing contamination of the photoresist. Such a coat can be used as top coat on a photoresist layer and provides thereby a contaminant barrier function. This contaminant barrier may diminish or prevent outgassing of compounds from the photoresist, e.g. in a lithographic apparatus. Such compounds (contaminants) are for example compounds selected from the group consisting of water, hydrocarbons and compounds comprising at least one atom selected from the group consisting of F, Si, P, S and Cl. However, the barrier does not only diminish or prevent diffusion of contaminants from the photoresist through the top coat (protection of e.g. optics in a lithographic apparatus), it also may reduce or prevent contamination of the photoresist (protection of the photoresist). Preferably, the contaminant barrier leads to a substantial reduction in diffusion of contaminants through the top coat in either direction, e.g. a diminishing in outgassing of at least 50 %, or e.g. 80 %.

In line with the embodiments mentioned above, the invention is also directed to e.g. an embodiment wherein the coat comprises one or more of the following polymers: polysilanes, polysilylenes, polysiloxanes, silylated polyhydroxystyrene, silane containing polymers, silsesquioxane polymers, acryl silane polymers, methacryl silane polymers and silylated polymers; an embodiment, wherein the coat is EUV transmissive; an embodiment, wherein the coat has a thickness such that the transmission of EUV radiation is higher than 50%; an embodiment, wherein the coat has a transmission for DUV and UV radiation of less than 50%; etc.

The invention is also directed to a substrate with a photoresist layer, wherein the substrate has an EUV transmissive top coat on the photoresist layer, wherein the EUV transmissive top coat comprises a polymer comprising a group with one or more of the following atoms: beryllium, boron, carbon, silicon, zirconium, niobium and molybdenum.

A "substrate" is defined as a wafer, for application in lithographic apparatus. Such substrates (or wafers) are known in the art (substrates or wafers for lithographic use like e.g. 8 or 12 inch wafers).

The photoresist layer will usually comprise an EUV photoresist. In another aspect, the invention is also related to the use of an EUV transmissive top coat on a photoresist layer, e.g. in EUV lithography. Such EUV transmissive top coat can e.g. be used as protective coating for the resist and/or to prevent contamination of the resist.

According to a further aspect of the invention, there is provided a device which is manufactured using the method of the invention.

In another aspect of the invention, the invention is also directed to a lithographic projection apparatus comprising:
- a radiation system, for supplying a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate; and
- a substrate for EUV lithography being at least partially covered by a photoresist layer, characterised by an EUV transmissive top coat on the photoresist layer, wherein the EUV transmissive top coat comprises a polymer comprising a group with one or more of the following atoms: beryllium, boron, carbon, silicon, zirconium, niobium and molybdenum.

The above described embodiments with respect to the method, coat and substrate with photoresist layer of the invention also relate to the lithographic apparatus of the invention.

Herein, the phrase "a polymer comprising a group with one or more of the following atoms: beryllium, boron, carbon, silicon, zirconium, niobium and molybdenum", indicates a polymer having at least one of such groups. The polymer may also have more of such groups like e.g. polysilane. Such "group" may comprise one or more of these atoms. The person skilled in the art will understand that such group may also comprise other atoms, like e.g. a silane group comprising Si and C. The term "group" in this invention is directed to chemical groups as known to the person skilled in the art like silane or siloxane groups. It may also indicate e.g. a polymer that is loaded with at least one of these atoms (e.g. boron loaded polyimide). In the context of the invention, "a polymer", "a group", "an atom", etc. may also mean combinations of polymers, groups and atoms, respectively.

Although specific reference may be made in this text to the use of a lithographic apparatus in the manufacture of ICs, it should be explicitly understood that the method of the invention is not confmed to the use of such an apparatus, but that the method has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle" or "die" in this text should be considered as being replaced by the more general terms "mask", and "target portion", respectively.

With the term "EUV radiation" in the invention is meant radiation of all types of electromagnetic radiation having a wavelength between about 5-20 nm, e.g. around 13 nm. The term 'layer' can also comprise a number of layers. The term 'coat' or 'coating' comprises the term 'layer'.

Embodiments of the invention will now be described, by way of example only, starting with a description of a lithographic apparatus, and with reference to the accompanying schematic drawings in which corresponding reference symbols indicate corresponding parts, and in which:
- Figure 1 depicts a lithographic projection apparatus according to an embodiment of the invention;
- Figure 2 depicts a substrate with photoresist layer and EUV transmissive top coat;
- Figure 3 depicts the transmission of a 10 nm silicon layer as function of the wavelength.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localised electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required; and
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (or photoresist layer). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus - commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, both incorporated herein by reference.

### Embodiment 1

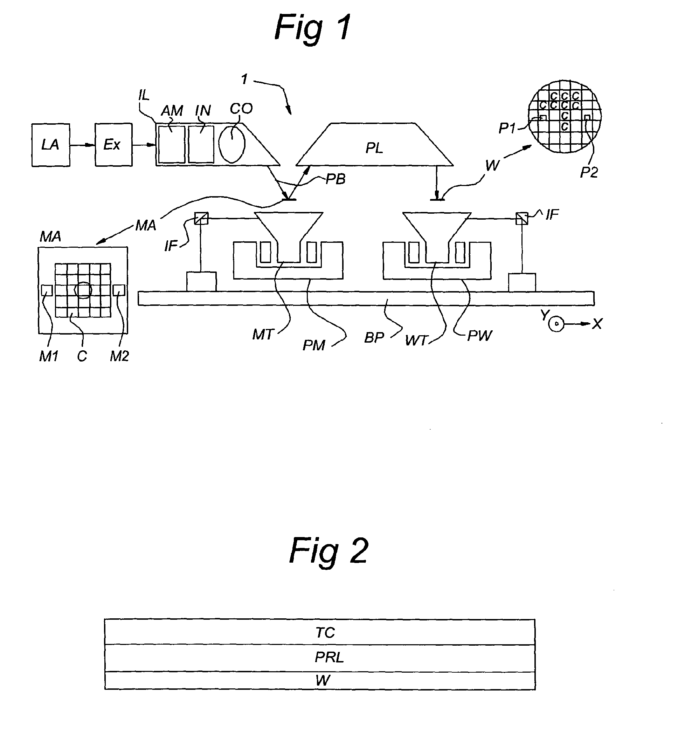

Figure 1 schematically depicts a lithographic projection apparatus 1 according to a particular embodiment of the invention. The apparatus comprises:
- a radiation system LA (comprises a radiation source, e.g. a xenon source), a beam expander Ex, and an illumination system IL, for supplying a projection beam PB of radiation (e.g. 13.5 nm radiation);
- a first object table (mask table) MT provided with a mask holder for holding a mask MA (e.g. a reticle), and connected to first positioning means PM for accurately positioning the mask with respect to item PL;
- a second object table (substrate table) WT provided with a substrate holder for holding a substrate W (e.g. a resist-coated silicon wafer), and connected to second positioning means PW for accurately positioning the substrate with respect to item PL; and
- a projection system ("lens") PL (e.g. refractive, catadioptric or reflective optics) for imaging an irradiated portion of the mask MA onto a target portion C (e.g. comprising one or more dies) of the substrate W.
As here depicted, the apparatus is of a reflective type (i.e. has a reflective mask). However, in general, it may also be of a transmissive type, for example (with a transmissive mask). Alternatively, the apparatus may employ another kind of patterning means, such as a programmable mirror array of a type as referred to above.

The source LA produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is a laser. The current invention and claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means PW (and interferometric measuring means IF), the substrate table WT can be moved accurately, e.g. so as to position different target portions C in the path of the beam PB. Similarly, the first positioning means PM can be used to accurately position the mask MA with respect to the path of the beam PB, e.g. after mechanical retrieval of the mask MA from a mask library, or during a scan. In general, movement of the object tables MT, WT will be realised with the aid of a long-stroke module (coarse positioning) and a short-stroke module (fine positioning), which are not explicitly depicted in figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:
1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB; and
2. In scan mode, essentially the same scenario applies, except that a given target portion C is not exposed in a single "flash". Instead, the mask table MT is movable in a given direction (the so-called "scan direction", e.g. the y direction) with a speed v, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

In this embodiment, an EUV transmissive top coat on a photoresist layer may comprise one or more of the following atoms: beryllium, boron, carbon, silicon, zirconium, niobium and molybdenum. It may further comprise one or more of the following polymers: polysilanes, polysilylenes, polysiloxanes, silylated polyhydroxystyrene, silane containing polymers, silsesquioxane polymers, acryl silane polymers, methacryl silane polymers and silylated polymers. E.g., the top coat has a final thickness such that the transmission of ELTV radiation is higher than 50%. This may result in a top coat that has a transmission for DUV and UV radiation of less than 50%.

The substrate of wafer W of figure 1 comprises on the surface of the wafer (e.g. a 300 mm wafer, 12 inch) a photoresist, e.g. EUV 2D resist (from Shipley). This photoresist layer is provided by spin coating, a technique known in the art, and the layer has a thickness of about 100 nm, but can also have another thickness, e.g. about 80-150 nm. On top of the photoresist, an EUV transmissive layer is present, with a thickness of about 50 nm. See e.g. figure 2, wherein W is the substrate, PRL is the photoresist layer and TC is the EUV transmissive top coat. Using spin coating also provides this layer. In this embodiment, the top coat is provided by spin coating a combination of silylated polyhydroxystyrene and as solvent propylenglycol monomethyletheracetate.

The following procedure is performed:
- preparing the surface of the substrate by cleaning and drying;
- coating the photoresist layer on the surface of the substrate by spin coating the photoresist layer on the surface of the substrate;
- heating the substrate during softbake, wherein a partial evaporation of the photoresist solvent takes place by the heating;
- cooling the substrate during 'chilling';
- spin coating the EUV transmissive top coat on the surface of the photoresist layer. After applying these processes, the procedure is followed with a subsequent heating and cooling.

The top coat is substantially transmissive for EUV radiation, but, in an embodiment, is substantially non-transmissive for UV or DUV radiation.

The lithographic apparatus of embodiment 1, may also be used in the other embodiments described below.

### Embodiment 2

This embodiment comprises most of the features as described above, but now a Novolac-based top coat is used. With respect to the commercially available water-based top coats, the Novolac-based top coat with a silylated polyhydroxystyrene substantially absorbs DUV radiation and has an improved EUV/DUV selectivity. The top coat may have a final thickness of 20-100 nm, e.g between 30-80 nm. Figure 2 describes schematically a substrate (W) with a photoresist layer (PRL), and on top of this layer an EUV transmissive top coat (TC).

### Embodiment 3

This embodiment comprises most of the features as described above in embodiment 1 or 2, but instead of applying soft-bake and cooling processes after applying the photoresist on the substrate W, the EUV transmissive top coat is applied on the photoresist layer, immediately after the coating of the photoresist layer. Subsequently, the procedure is followed by a soft-bake and cooling.

### Embodiment 4

After applying the photoresist on the substrate W, the substrate is applied to a soft-bake and cooling. Subsequently, via CVD, a silicon containing component layer is provided as top coat by CVD coating of a polymer and of a silylated polymer. The top coat is substantially transmissive for EUV radiation, but is substantially non-transmissive for UV or DUV radiation.

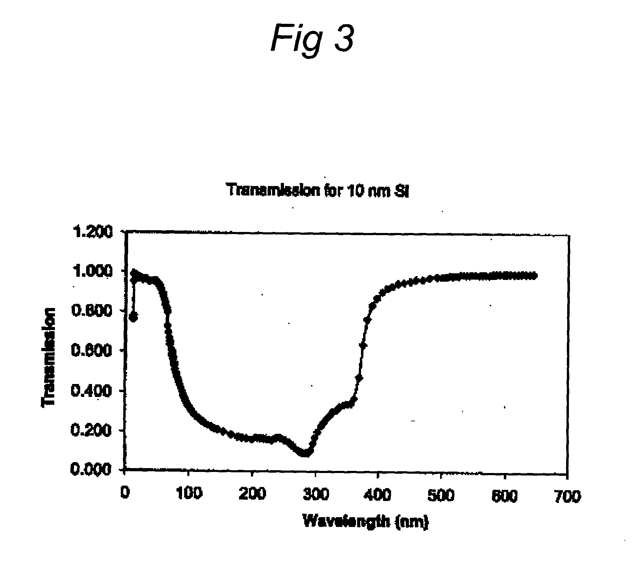

The transmission of a Si coating against the wavelength (in nm) is simulated in figure 3 for a 10 nm layer. This figure shows a coating that is substantially transmissive for EUV radiation, but which is substantially non-transmissive or only slightly transmissive for undesired UV or DUV radiation. Since the the trend of transmission versus wavelength of Si,C,H containing polymers compares well with that of Si, this figure shows that in general Si,C,H containing top coats, e.g. polymers with Si groups, or polymer layers with Si components can be applied (e.g. by CVD) as top coatings.

### Embodiment 5

After applying the photoresist on the substrate W, the substrate is applied to a soft-bake and cooling step. Subsequently, via CVD, a boron containing component layer is provided as top coat (B,C,H based top coat), e.g. by applying polymer and boron CVD.

### Embodiment 6

After applying a top coat according to embodiment 1, 2, 3, 4 or 5, the resist is exposed to EUV radiation. Subsequently, a post exposure bake is performed and than the top coat and resist is removed during a development step.

### Embodiment 7

After applying a top coat according to embodiment 1, 2, 3, 4 or 5, the resist is exposed to EUV radiation. Subsequently, a post exposure bake is performed and than the top coat is 'stripped' by a plasma etch process. Afterwards, the resist is removed during development.

### Embodiment 8

After applying a top coat according to embodiment 1, 2, 3, 4 or 5, the resist is exposed to EUV radiation. Subsequently, a post exposure bake is performed and than the top coat is ashed. Afterwards, the resist is removed during development.

### Embodiment 9

A top coat is applied according to the invention. The top coat is transmissive for EUV radiation, and absorbs DUV radiation. During exposure and processing, the photoresist is not charged, or charged less than with conventional top coats, due to the use of the EUV top coat as charge dissipating or conducting layer.

### Embodiment 10

This embodiment comprises most of the features as described in embodiment 1 or 2, but now silylated Novolac is used. With respect to the commercially available water-based top coats, the silylated Novolac-based top coat substantially absorbs DUV radiation and has an improved EUV/DUV selectivity. The top coat may have a final thickness of 20-100 nm, e.g between 30-80 nm.

Whilst specific embodiments of the invention have been described above, it will be appreciated that the invention may be practised otherwise than as described. The description of the embodiments and the figures are not intended to limit the invention. For example, other coating techniques, leading to EUV transmissive coatings might also be used. The EUV coatings might also comprise other atoms, that lead to suitable coatings being transmissive to EUV radiation. Further, the invention is not confined to the lithographic apparatus described in embodiment 1. The person skilled in the art will understand that the invention may also comprise combinations of the embodiments described herein.

## Claims

1. A method for coating a substrate for EUV lithography comprising coating a photoresist layer on the substrate, **characterised by** providing an EUV transmissive top coat on the photoresist layer, wherein the EUV transmissive top coat comprises a polymer comprising a group with one or more of the following atoms: beryllium, boron, carbon, silicon, zirconium, niobium and molybdenum.

2. A device manufacturing method using a lithographic projection apparatus comprising:
- providing a substrate that is at least partially covered by a photoresist layer by coating the photoresist layer on the substrate;
- providing a projection beam of radiation using a radiation system;
- using patterning means to endow the projection beam with a pattern in its cross-section; and
- projecting the patterned beam of radiation onto a target portion of the photoresist layer,
**characterised by** providing an EUV transmissive top coat on the photoresist layer, wherein the EUV transmissive top coat comprises a polymer comprising a group with one or more of the following atoms: beryllium, boron, carbon, silicon, zirconium, niobium and molybdenum.

3. Method according to claim 1 or 2, wherein the top coat comprises one or more of the following polymers: polysilanes, polysilylenes, polysiloxanes, silylated polyhydroxystyrene, silane containing polymers, silsesquioxane polymers, acryl silane polymers, methacryl silane polymers and silylated polymers.

4. Method according to one of the preceding claims, wherein the top coat has a final thickness such that the transmission of EUV radiation is higher than 50%.

5. Method according to one of the preceding claims, wherein the top coat has a transmission for DUV and UV radiation of less than 50%.

6. A coat for use as top coat on a photoresist layer, wherein the coat comprises a polymer comprising a group with one or more of the following atoms: beryllium, boron, carbon, silicon, zirconium, niobium and molybdenum, and wherein the coat enables at least on of a) a diminishing of outgassing of a contaminant from the photoresist layer and b) preventing contamination of the photoresist.

7. Coat according to claim 6, wherein the contaminant is a compound selected from the group consisting of water, hydrocarbons and compounds comprising at least one atom selected from the group consisting of F, Si, P, S and Cl.

8. Coat according to claim 6 or 7, wherein the coat comprises one or more of the following polymers: polysilanes, polysilylenes, polysiloxanes, silylated polyhydroxystyrene, silane containing polymers, silsesquioxane polymers, acryl silane polymers, methacryl silane polymers and silylated polymers.

9. Coat according to one of claims 6-8, wherein the coat is EUV transmissive.

10. Coat according to claim 9, wherein the coat has a thickness such that the transmission of EUV radiation is higher than 50%.

11. Coat according to of claim 9 or 10, wherein the coat has a transmission for DUV and UV radiation of less than 50%.

12. A Substrate with photoresist layer, **characterised by** an EUV transmissive top coat on the photoresist layer, wherein the EUV transmissive top coat comprises a polymer comprising a group with one or more of the following atoms: beryllium, boron, carbon, silicon, zirconium, niobium and molybdenum.

13. Substrate according to claim 12, wherein the photoresist layer comprises an EUV photoresist.

14. Lithographic projection apparatus comprising:
- a radiation system, for supplying a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate; and
- a substrate for EUV lithography being at least partially covered by a photoresist layer, **characterised by** an EUV transmissive top coat on the photoresist layer, wherein the EUV transmissive top coat comprises a polymer comprising a group with one or more of the following atoms: beryllium, boron, carbon, silicon, zirconium, niobium and molybdenum.

15. Use of an EUV transmissive top coat on a photoresist layer as charge dissipating or conducting layer.

16. Method according to one of claims 1-5, wherein the top coat comprises silicon or boron.

17. Method according to one of claims 1-5, or 16, wherein the top coat has a final thickness of 20-100 nm.

18. Method according to one of claims 1-5, 16 or 17, wherein the top coat has a final thickness of 30-80 nm

19. Method according to one of claims 1-5, or 16-18, wherein the EUV transmissive top coat on the photoresist layer is provided by spin coating or chemical vapour deposition (CVD).

20. Use of an EUV transmissive top coat on a photoresist layer, wherein the EUV transmissive top coat comprises a polymer comprising a group with one or more of the following atoms: beryllium, boron, carbon, silicon, zirconium, niobium and molybdenum.

21. Use of a top coat on a photoresist layer as a contaminant barrier.

22. Use according to claim 21, wherein the contaminant is a compound selected from the group consisting of water, hydrocarbons and compounds comprising at least one atom selected from the group consisting of F, Si, P, S and Cl.

23. Use according to claim 21 or 22, wherein the top coat is EUV transmissive.
